(19) Europäisches Patentamt
European Patent Office
Office européen des brevets

(11) **EP 3 642 039 B1**

(12) **EUROPÄISCHE PATENTSCHRIFT**

(45) Veröffentlichungstag und Bekanntmachung des Hinweises auf die Patenterteilung:
**20.04.2022   Patentblatt 2022/16**

(21) Anmeldenummer: **18735220.8**

(22) Anmeldetag: **21.06.2018**

(51) Internationale Patentklassifikation (IPC):
*B33Y 30/00* (2015.01)     *B29C 64/209* (2017.01)
*B29C 64/255* (2017.01)     *B29C 64/321* (2017.01)
*G03F 7/20* (2006.01)     *B22F 3/105* (2006.01)
*B29K 105/00* (2006.01)     *A61C 13/00* (2006.01)

(52) Gemeinsame Patentklassifikation (CPC):
**B33Y 30/00; B29C 64/209; B29C 64/255; B29C 64/321; G03F 7/0037;** B29C 64/124; B29K 2105/0058; B33Y 10/00

(86) Internationale Anmeldenummer:
**PCT/EP2018/066528**

(87) Internationale Veröffentlichungsnummer:
**WO 2018/234426 (27.12.2018 Gazette 2018/52)**

(54) **BEHÄLTER ZUM EINSATZ IN STEREOLITHOGRAPHIE-ANLAGEN**

CONTAINER FOR USE IN STEREOLITHOGRAPHIC SYSTEMS

CONTENANT S'UTILISANT DANS DES INSTALLATIONS DE STÉRÉOLITHOGRAPHIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.06.2017   DE 102017210384**

(43) Veröffentlichungstag der Anmeldung:
**29.04.2020   Patentblatt 2020/18**

(73) Patentinhaber: Sirona Dental Systems GmbH
**64625 Bensheim (DE)**

(72) Erfinder: **SCHMIDT, Christian**
**64625 Bensheim (DE)**

(74) Vertreter: **Singh, Tajeshwar**
**Sirona Dental Systems GmbH**
**Corporate Legal**
**Fabrikstraße 31**
**64625 Bensheim (DE)**

(56) Entgegenhaltungen:
**EP-A1- 1 863 070**          **WO-A1-2016/149104**
**DE-A1-102013 215 040**      **US-A1- 2017 151 718**

**Beschreibung**

Gebiet der Erfindung

Die Erfindung betrifft einen Teil einer Stereolithographie-Anlage.

In einer Stereolithographie-Anlage wird durch schichtweises oder kontinuierliches Aneinanderreihen von Schichten bzw. Schichtinformationen ein dreidimensionaler Körper aus einer fotosensitiven Substanz erzeugt.

Bei der Stereolithographie nach dem Überkopf-Verfahren wird die erste Schicht des Werkstücks, d.h. vor dem ersten Schritt des eigentlichen generativen Prozesses, auf einen Träger übertragen (z.B. durch einen Polymerisationsprozess angeheftet). Der Träger ist in der Lage, eine Relativbewegung zur Fokusebene bzw. Referenzschicht durchzuführen. In einem nächsten Verfahrensschritt wird dafür gesorgt, dass neues Material der fotosensitiven Substanz unter der zuletzt erzeugten Schicht oder Polymerisationsfront in die Referenzschicht nachfließen kann; dies kann beispielsweise durch eine einfache Hubbewegung oder eine Kombination von Hubbewegungen erfolgen. Daraufhin kann die nachgeflossene fotosensitive Substanz wieder durch Belichten aushärten.

Bei der Stereolithographie nach dem Überkopf-Verfahren befindet sich die Referenzschicht unmittelbar unterhalb des Werkstücks, über dem Boden der Wanne bzw. des Behälters, in der/dem sich das flüssige Ausgangs-Material (z.B. photopolymerisierbares Kunstharz) befindet.

Dabei muss beim Anheben des Werkstücks, um die jeweils nächste Schicht aushärten zu können, dafür gesorgt werden, dass die letzte, gerade ausgehärtete Schicht des Werkstücks nicht am Wannenboden haftet.

Stand der Technik

Aus dem Stand der Technik sind diverse Lösungen bekannt, welche den Einsatz von Inhibitoren zur Beschleunigung des Verfahrens bis hin zu einem kontinuierlichen Herstellungsprozess ermöglichen.

Der Einsatz von Inhibitoren zur Ausbildung einer reaktionsträgen Zwischenphase innerhalb eines fotoreaktiven Harzes wurde zum Beispiel von Lawton in US 5,391,072 beschrieben. Dabei wird der Einsatz einer Teflon-AF-Folie bzw. von Fluor-Polymeren beschrieben, die auf einem Träger befestigt werden, um zwischen dem Träger und der Folie einen zum Beispiel gasförmigen Inhibitor von außen einströmen zulassen. Dabei dringt der Inhibitor (z.B. Sauerstoff) durch die Teflon-AF-Folie und erzeugt so eine unreaktive Inhibierungs-Schicht innerhalb bzw. unmittelbar unter der darüberliegenden fotoreaktiven Referenzschicht. Es bildet sich ein Schmierfilm aus, der das Lösen des Werkstücks vom Boden der Wanne deutlich erleichtern und somit den Prozess beschleunigen kann.

Die Veröffentlichung von Fricke (WO 01/72501 A1) beschreibt eine Stereolithographie-Anlage, die in der Lage ist, ein Werkstück kontinuierlich, also ohne Pausen zwischen den Schichten, herzustellen. Dabei wird der Polymerisationsvorgang nicht unterbrochen und das Werkstück kontinuierlich mit einer mit der Kinetik der Reaktionsfront im Zusammenhang stehenden Geschwindigkeit aus dem flüssigen fotoreaktiven Material gezogen. Dazu beschreibt Fricke auch den Einsatz von Maskenbelichtungssystemen, die es ermöglichen, die Schichtinformation in jedem Punkt der Belichtungsebene bzw. Referenzschicht simultan zu erzeugen. Die Ausbildung der für einen kontinuierlichen Prozess notwendigen unreaktiven Phase wird von Fricke durch Kühlen der fotoreaktiven Flüssigkeit erreicht, um so ein Reaktionsgefälle innerhalb der fotoreaktiven Substanz zu erzeugen. Auf diese Weise können Druckgeschwindigkeiten von 1 mm/s erreicht werden.

In der Veröffentlichung von Willis, US 2015/0360419 A1, wird eine Stereolithographie-Anlage mit einer Wanne offenbart, die aus einem Material besteht, das über eine gewisse Sauerstoffdurchlässigkeit verfügt. Dies ermöglicht die Ausbildung einer inhibitorhaltigen Schicht, die zur Reduktion der Trennkraft führt. Als sauerstoffdurchlässiges Material wird Teflon AF bzw. ein Fluor-Polymer eingesetzt. Auch wird ein Zweiphasensystem beschrieben, wobei sich zwischen Behälter und fotoreaktiver Substanz eine transparente, chemisch inerte Flüssigkeit befindet.

Die Veröffentlichung DE 20 2013 103 446 U1 beschreibt den Einsatz einer semipermeablen Membran zur Erzeugung einer Inhibierungs-Schicht innerhalb der fotoreaktiven Flüssigkeit zur Minimierung der Trennkräfte.

Die Patentschrift US 5,545,367 von Young offenbart in Fig. 13a einen Aufbau, der aus einem Fluor-Polymer und einem strukturierten Träger besteht. Dabei kann beispielsweise ein gasförmiger Inhibitor in den vom Träger gebildeten Kanälen strömen und so das Anhaften der Schichten des Werkstücks an der Oberseite des Trägers durch Ausbildung einer inhibitorhaltigen Schicht minimieren.

Diverse andere Veröffentlichungen, wie zum Beispiel US 2013/0252178 A1, US 2015/0309473 A1, US 2013/0292862 A1 und EP 1 253 002 B1 beschreiben den Einsatz von PDMS (Silikon) als untere Begrenzung der Referenzschicht, z.B. als Wannenboden. Dabei bildet der im Silikon gelöste Sauerstoff durch Diffusion eine sehr schmale Inhibierungsschicht innerhalb des fotoreaktiven Materials aus und verringert somit die Haftkräfte. Der größte Nachteil liegt hierbei in der geringen chemischen und mechanischen Stabilität der PDMS-Schicht.

In US 2013/0295212 A1 wird von Yong ebenfalls der Einsatz von PDMS als Trennmedium und die damit verbundene Ausbildung einer Inhibierungsschicht beschrieben und ein messtechnischer Zusammenhang zwischen der Inhibierungsschicht und der Trennkraft dargestellt. Durch Reduktion der Trennkräfte sowie durch das Abscheren der Wanne von der Werkstückoberfläche konnte der Herstellungsprozess gegenüber konventionellen Systemen beschleunigt werden.

Die Veröffentlichung WO 2016/149097 A1 von Tumbleston beschreibt einen kontinuierlichen Herstellungsprozess, in dem ebenfalls eine Zwischenphase innerhalb des fotoreaktiven Materials ausgebildet wird. Dies wird durch den Einsatz einer Teflon-AF-Folie bzw. einer Membran ermöglicht, die über einer Basis angeordnet ist. Dabei kann die Teflon-AF-Folie, wie bereits von Lawton beschrieben, mit der Basis verbunden sein. Auch wird die Möglichkeit aufgezeigt, die Folie nicht mit der Basis zu verbinden, um so einen zusätzlichen mechanischen Ablöseprozess zu ermöglichen. Dabei besteht die Basis unter anderem aus einem transparenten, für den Inhibitor nicht permeablen Werkstoff, z.B. Glas. Unter Umständen kann die nicht-permeable Schicht auch durch Strukturierung oder Bearbeitung zu einem gewissen Maße permeabel gemacht werden.

Die Veröffentlichung DE 10 2013 215 040 A1 beschreibt eine Überkopf-Stereolithographie-Anlage, die aufgrund von optischen Umlenkeinrichtungen, bei denen Totalreflexion auftritt, besonders kompakt gestaltet ist. Eine semipermeable Folie, die einen Hohlraum überspannt, dient hierbei der Zuführung des Inhibitors.

Aus der WO 2016/149104 A1 ist ein poröse Basisplatte mit einem gasdurchlässigen biegbaren Schichtenanteil bekannt, welches über eine poröse Klebeschicht miteinander verbunden sind. Dabei kann die Basisplatte gebohrte Mikrolöcher mit einem Durchmesser von 10 bis 50 μm aufweisen.

In der Veröffentlichung US 2017/0151718 A1 werden Verfahren zur Stereolithographie beschrieben, die Gegenstände aus Polyurethan und verwandten Substanzen erzeugen können. Dabei können auch Überkopf-Anordnungen zum Einsatz kommen. Die Grundplatte, durch die in diesen Fällen ein Inhibitor zugeführt werden kann, kann hierbei eine Schicht aus z.B. Teflon AF oder einer anderen semipermeablen Folie aufweisen. Alternativ oder ergänzend dazu wird beschrieben, die Grundplatte aus z.B. porösem oder mikroporösem Glas zu fertigen.

Alle bekannten Lösungen haben den Nachteil, dass sie nicht beliebig in der Größe skalierbar sind und meist komplizierte optische Herstellungsverfahren benötigen, um beispielsweise Kanalstrukturen zu bilden. Weiterhin sind Stoffe wie PDMS zwar grundsätzlich sauerstoffdurchlässig, jedoch verhält sich diese Durchlässigkeit gegensätzlich zum Vernetzungsgrad. Dieser bestimmt wiederum maßgeblich die mechanische wie auch chemische Stabilität. Freitragende PDMS-Anordnungen haben den Nachteil, dass sie flexibel sind und somit ein Wölben während des Herstellungsprozesses nicht verhindert werden kann. Starre Materialen wie Glas haben dagegen zwar mechanische und optische Vorteile, bieten aber keine Möglichkeit zur Diffusion eines gasförmigen Inhibitors, so dass es nicht zur Ausbildung einer Inhibierungsschicht kommt. Die Verwendung von Teflon AF ist als Folie oder als Plattenmaterial möglich. Die Kosten von Teflon AF sind jedoch sehr hoch, insbesondere in Plattenform. Außerdem würde auch mit zunehmender Dicke der Platte und der damit einhergehenden mechanischen Stabilität die Sauerstoffdurchlässigkeit sinken. Der Einsatz als (freitragende) Folie scheitert an der Durchbiegung der Folie, so dass diese eine Basis benötigt, um einen schnellen, ggf. sogar kontinuierlichen Herstellungsprozess zu ermöglichen.

Aufgabe

Ziel der hier vorgestellten Erfindung ist es, eine Anordnung zu schaffen, die die Nachteile der bekannten Lösungen überwindet und ein einfaches Zuführen des Inhibitors bei ausreichend mechanisch starrer Basis ermöglicht.

Lösung

Diese Aufgabe wird durch den Gegenstand des unabhängigen Anspruchs gelöst. Vorteilhafte Weiterbildungen des Gegenstands des unabhängigen Anspruchs sind in den Unteransprüchen gekennzeichnet. Der Wortlaut sämtlicher Ansprüche wird hiermit durch Bezugnahme zum Inhalt dieser Beschreibung gemacht.

Die Verwendung der Einzahl soll die Mehrzahl nicht ausschließen, was auch im umgekehrten Sinn zu gelten hat, soweit nichts Gegenteiliges offenbart ist.

Zur Lösung der Aufgabe wird ein Behälter zur Aufnahme einer fotosensitiven Flüssigkeit vorgeschlagen, welche zur Verwendung in einer Stereolithographie-Anlage vorgesehen ist, in der eine Referenzschicht zum schichtweisen oder kontinuierlichen Aufbauen von Werkstücken mit Strahlung belichtet wird. Mindestens ein Element des Behälters, das unmittelbar an die Referenzschicht grenzt, besteht aus zumindest einem Material, welches für die Strahlung durchlässig ist und Strukturen und/oder Poren aufweist, die in der Lage sind, einen Inhibitor und/oder ein Inhibitor-Gemisch zu speichern oder aufzunehmen und abzugeben.

Das Material des Elements des Behälters ist vorzugsweise ein Festkörper, der zu mindestens 70 Vol-%, vorzugsweise zu mindestens 80 Vol-%, vorzugsweise zu mindestens 90 Vol-%, vorzugsweise zu mindestens 95 Vol-%, vorzugsweise zu mindestens 98 Vol-%, vorzugsweise zu mindestens 99 Vol-%, aus offenzelligen Poren besteht. Das Element des Behälters besteht also aus einem Material, das typischerweise zu 80 oder mehr Prozent aus einem Gas (z.B. Luft) besteht. Das Material enthält also (für den Fall, dass z.B. Kunstharz zur Stereolithographie verwendet wird) einen Inhibitor, beispielsweise Sauerstoff. Trotzdem ist das Material fest genug, um den Boden einer Wanne bzw. den Deckel eines Behälters daraus zu gestalten, wobei dieser Boden bzw. Deckel typischerweise eine Dicke von 100 μm bis 1 cm, bevorzugt von 3 mm hat, abhängig von der Größe des Behälters.

In dieser Konstellation ist das Element für die bei der Stereolithographie verwendete Strahlung, z.B. UV-Strahlung, zumindest teilweise durchlässig. Für die Flüssigkeit in dem Behälter, typischerweise ein flüssiges, photopolymerisierbares Kunstharz, ist das Material dagegen undurchlässig. Der Bereich des Bodens der Wanne, oberhalb dessen sich die Referenzschicht befindet, kann also nicht bloß den Inhibitor zuführen, sondern besteht zu einem signifikanten Anteil aus dem Inhibitor selbst. Gleiches gilt bei der Nutzung als Deckel des Behälters. Dadurch kann ein ggf. räumlich begrenzter Inhibitor-Zufluss ausgeglichen bzw. homogenisiert werden. Der Wannenboden bzw. Behälterdeckel speichert gewissermaßen den gasförmigen Inhibitor in sich. Bei der Gestaltung des Wannenbodens bzw. Behälterdeckels kann folglich auf spezielle Zuführungen oder Kanäle, die dazu dienen, den Inhibitor zuzuführen, verzichtet werden. Der Inhibitor kann vielmehr durch Änderung des Umgebungsdruckes oder der -temperatur zugeführt und/oder abgeführt werden. Es ist möglich, den ganzen Boden bzw. Deckel oder nur den Teil des Bodens der Wanne bzw. Deckels des Behälters, der sich unterhalb/oberhalb der Referenzschicht befindet, aus dem Material zu gestalten. Dieser Bereich kann also von herkömmlichen Konstruktionsmaterialien umgeben sein und/oder gestützt werden, die ihrerseits nur über eine geringe oder keine Durchlässigkeit für einen Inhibitor verfügen.

Insgesamt ergibt sich also eine wesentlich einfachere und kostengünstigere Gestaltung des Behälters oder der Kartusche, als bei der Verwendung anderer semipermeabler Stoffe zur Zuführung des Inhibitors. Auch ist die Ausführung nahezu beliebig skalierbar, so dass auch größere Stereolithographie-Anlagen problemlos damit ausgerüstet werden können. Die Zuführung eines gasförmigen Inhibitors zum fotoreaktiven Material im Behälter ist gewährleistet, so dass unterhalb bzw. oberhalb der Referenzschicht ein Reaktionsgradient entsteht und insbesondere unmittelbar am Boden der Wanne bzw. Deckel des Behälters keine Verklebung mit demselben stattfindet. Dies ist Voraussetzung für einen schnellen, bevorzugt kontinuierlichen, Stereolithographie-Prozess. Mechanische Abscher- oder Rüttelvorrichtungen zum Abtrennen der gerade verfestigten Schicht vom Wannenboden oder Behälterdeckel können komplett entfallen.

Der Behälter zur Aufnahme der fotosensitiven Flüssigkeit kann bevorzugt eine Wanne zur Verwendung in einer Stereolithographie-Anlage, welche nach dem Überkopf-Verfahren arbeitet, sein. In dem Fall ist das Element der Wanne, das unmittelbar an die Referenzschicht grenzt, zumindest ein Teil des Bodens der Wanne.

Der Behälter kann jedoch auch zur Aufnahme der fotosensitiven Flüssigkeit zur Verwendung in einer Auflicht-Stereolithographie-Anlage dienen. In dem Fall ist das Element des Behälters, das unmittelbar an die Referenzschicht grenzt, zumindest ein Teil des Deckels des Behälters.

Vorzugsweise beträgt die Porengröße des Materials zwischen 2 und 200 nm, vorzugsweise zwischen 2 und 50 nm, besonders bevorzugt zwischen 30 und 50 nm. Diese Porengröße ist kleiner als die Wellenlänge des für die Polymerisierung verwendeten Lichts (typischerweise UV-Licht). Damit kommt es kaum zu Lichtstreuung. Die Poren sind aber auch groß genug, um Luft, Sauerstoff bzw. den Inhibitor speichern und transportieren zu können. Ferner sind sie klein genug, um die photopolymerisierbare Flüssigkeit nicht in das Material eindringen zu lassen.

Bevorzugte Materialien für das Element sind nanoporöse Komposite, nanoporöses Glas oder Aerogele.

Bessere Materialeigenschaften, z.B. eine höhere Transparenz für die bei der Stereolithographie verwendete Strahlung, lassen sich erreichen, wenn das Aerogel dotiert ist (auch X-Aerogel genannt). Insbesondere werden bessere mechanische Eigenschaften (d.h. Stabilität bzw. Festigkeit) erhalten, wenn das Aerogel mit Nanozellulose dotiert ist, während eine erhöhte chemische Widerstandsfähigkeit erzielt wird, wenn das Aerogel mit Polydimethylsiloxan (PDMS) dotiert ist.

Ein besonders einfacher Aufbau wird dadurch erreicht, dass der aus einem Aerogel bestehende Teil des Bodens der Wanne einschichtig ausgeführt ist. Diese Ausführungsform ist zudem besonders kostengünstig. Mit einem entsprechend dotierten Aerogel lässt sich das problemlos erreichen.

Vielseitiger ist ein Aufbau, bei dem der aus einem Aerogel bestehende Teil des Bodens der Wanne bzw. des Deckels des Behälters aus mindestens zwei Schichten besteht. Dabei kann auch mindestens eine Schicht aus einem konventionellen Material, beispielsweise Glas, bestehen, das z.B. zur Stabilisierung dient. Im Falle einer Schicht aus für den Inhibitor undurchlässigem Material muss diese Schicht auf der von der photopolymerisierbaren Flüssigkeit abgewandten Seite der übrigen Schichten angeordnet sein, um den Fluss des Inhibitors in den Behälter hinein nicht zu blockieren. Vorteilhafter sind hierbei jedoch Varianten, bei denen die Schichten aus verschiedenen semipermeablen Materialien bestehen, die alle für den Inhibitor zumindest begrenzt durchlässig sind. Die Schichten können z.B. durch ein Silikon miteinander verklebt sein, oder es könnte eine komplette Schicht aus Silikon bestehen. Andere Formen des Verbindens der Schichten, z.B. Klemmen, Spannen o.ä., können auch in Betracht gezogen werden. Eine Anordnung mit mehreren Schichten, die alle aus Aerogelen bestehen, ist ebenso möglich, wobei diese Schichten jeweils unterschiedlich dotiert sein können, um z.B. an den Außenflächen eine besonders hohe chemische Stabilität und bei einer inneren Schicht eine besondere mechanische Festigkeit des Wannenbodens bzw. Behälterdeckels zu erzielen. Insbesondere sind auch Sandwich-artige Strukturen möglich. Schichten aus Teflon AF können auch von Vorteil sein. Teflon AF hat hierbei den Vorteil, für Sauerstoff eine deutlich höhere Durchlässigkeit als für Stickstoff zu besitzen. Falls Luft als Träger des Inhibitors zum Einsatz kommt, was aus Kosten- und Handhabbarkeitsgründen empfehlenswert ist, kann eine Teflon-AF-Schicht also dafür sorgen, dass vor allem der Inhibitor, Sauerstoff, dem Behälterinneren zugeführt wird, und nicht in der Hauptsache Stickstoff, der hier keine sinnvolle Wirkung erreicht. Eine geeignete Anordnung aus mehreren Schichten kann eine für die jeweilige Anwendung maßgeschneiderte Speicherung und Durchlässigkeit für den Inhibitor ermöglichen.

Das Element kann dadurch chemisch stabiler gemacht werden, dass der aus dem Material bestehende Teil des Bodens der Wanne bzw. des Deckels des Behälters auf der Innenseite der Wanne beschichtet ist. Diese Beschichtung kann z.B. die Form einer Membran haben. Besonders vorteilhaft ist dabei, wenn die Beschichtung aus einem Fluoropolymer besteht, beispielsweise aus einer Teflon-AF-Folie. Alternativ ist es vorteilhaft, wenn die Beschichtung aus einem Silikon besteht. Mit diesen Beschichtungen lassen sich ähnliche Vorteile erzielen wie mit einem mehrschichtigen Aufbau, wie er weiter oben beschrieben wurde. Zudem ist die Herstellung einfacher, da die Beschichtung in Form einer Folie auf die Oberfläche des aus einem Aerogel bestehenden Teils des Bodens der Wanne bzw. Deckels des Behälters aufgebracht werden kann. Verkleben, Klemmen oder Aufspannen sind hierbei bevorzugte Befestigungsmöglichkeiten für eine solche Folie. Beschichtungen mit Teflon AF, PDMS (ein Silikon) oder PTMSP können allerdings vorteilhafterweise aufgeschmolzen werden, was durch die Temperaturunempfindlichkeit von Aerogelen erleichtert wird. PDMS steht für Polydimethylsiloxan und PTMSP für Poly(1-trimethylsilyl-1-propyne), welche über eine gewisse Sauerstoff-Durchlässigkeit verfügen.

Wenn der aus einem Aerogel bestehende Teil des Bodens der Wanne bzw. Deckels des Behälters so konfiguriert ist, dass die Porengröße des Elements bzw. Materials sich über seine räumliche Ausdehnung in mindestens einer Richtung ändert, lässt sich die Aufnahme und/oder Abgabe des Inhibitors, z.B. Sauerstoff, optimieren. Bevorzugt ändert sich die Porengröße in Richtung des Photopolymers, zum Beispiel von einer Porengröße im Bereich von Mikrometern auf der Seite zur Umgebungsluft hin sich verkleinernd und zu einer Porengröße im Nanometerbereich bei Annäherung an die photopolymerisierbare Flüssigkeit, oder umgekehrt. Vorteilhafterweise ist ein zumindest teilweise geschlossenes Volumen auf der vom Photopolymer abgewandten Seite des Elements ausgebildet, das es ermöglicht, Zustandsgrößen sowie die Zusammensetzung der Atmosphäre in dem Volumen zumindest teilweise zu kontrollieren. Dies ermöglicht es, Zustandsgrößen wie Druck, Temperatur, Inhibitor-Konzentration in und um das Element sowie die Zusammensetzung der Atmosphäre des Volumens zumindest teilweise zu kontrollieren, bevorzugt unabhängig und/oder abhängig von den Umweltbedingungen. Dies ermöglicht es, den Fluss des Inhibitors in die Referenzschicht gezielt zu steuern.

Bei einer weiteren Ausführungsform mit einer Verpackung ist die weiter oben beschriebene Wanne mit einer fotosensitiven Flüssigkeit zur Verwendung in einer Stereolithographie-Anlage gefüllt. Zudem befindet sie sich in der Verpackung, welche derart beschaffen ist, dass die fotosensitive Flüssigkeit in der Wanne gehalten wird. Die Verpackung kann z.B. eine abziehbare Deckschicht etwa aus Kunststoff umfassen, die die Wanne verschließt. Die fotosensitive Flüssigkeit ist in der Verpackung gegen die zur Stereolithographie verwendete Strahlung abgeschirmt. Eine so ausgeführte Wanne oder auch Kartusche kann als Verbrauchsmaterial für bereits vorliegende Stereolithographie-Anlagen zum Einsatz kommen. Häufig ist es sinnvoll, das Element durch ein Trägermaterial zumindest bereichsweise mechanisch zu unterstützen. Das Trägermaterial muss natürlich für die eingesetzte Strahlung transparent sein. Das Element wird dabei bevorzugt mit dem Trägermaterial verbunden sein, wobei das Trägermaterial nicht zwingend für den Inhibitor durchlässig sein muss. So kann zum Beispiel ein ausreichend dickes und damit ausreichend mechanisch stabiles Trägerglas verwendet werden, auf dem ein dünnes Aerogel mit einer Dicke von lediglich 1 mm aufgebracht ist.

Die Aufgabe wird ferner gelöst durch eine Stereolithographie-Anlage, welche nach dem Überkopf-Verfahren arbeitet, mit mindestens einer Wanne zur Aufnahme einer fotosensitiven Flüssigkeit, wie sie weiter oben beschrieben worden ist.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.

Ein Ausführungsbeispiel ist in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente.

Kurzbeschreibung der Zeichnungen

Im Einzelnen zeigt:

Fig. 1     eine perspektivische Ansicht einer erfindungsgemäßen Wanne;

Fig. 2     die Wanne aus Fig. 1 in Explosionsdarstellung;

Fig. 3     eine schematische Schnittansicht durch die Wanne aus Figuren 1 und 2; und

Fig. 4     eine vereinfachte perspektivische Ansicht eines 3D-Druckers mit einer erfindungsgemäßen Wanne.

Ausführungsbeispiele

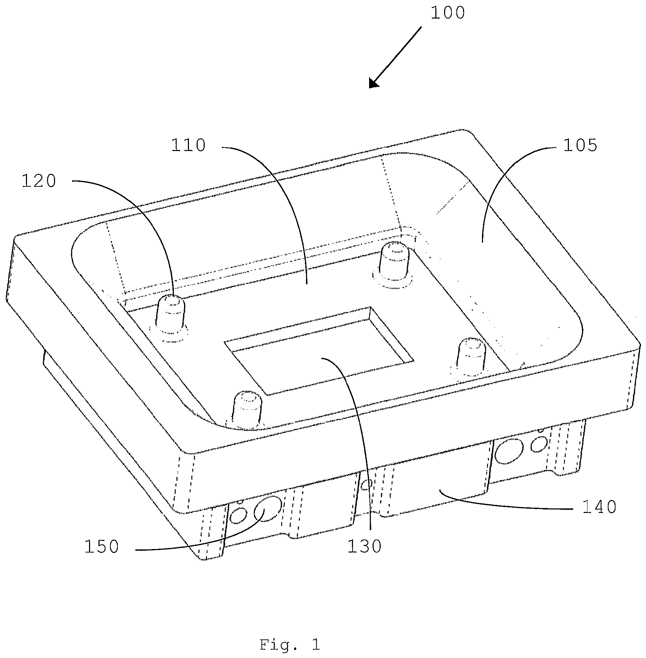

Eine erfindungsgemäße Wanne 100 für den Einsatz in einer Überkopf-Stereolithographie-Anlage ist in Fig. 1 dargestellt. In dieser Ausführung können die Wand 105 und der äußere Bereich 110 des Bodens der Wanne, über dem sich die Referenzschicht nicht befindet, aus einem konventionellen Material gefertigt sein. Vier Abdeckungen 120 für Montageschrauben befinden sich in diesem Bereich. In der Mitte der Wanne liegt der Bereich, wo sich im Betrieb über dem Wannenboden die Referenzschicht befindet. In dem konventionell gefertigten Wannenboden 110 ist dort eine Aussparung, unter der sich ein Block 130 befindet, der vorzugsweise aus einem Aerogel oder aus einer der oben beschriebenen Kombinationen unterschiedlicher Schichten mit mindestens einem Aerogel besteht. Vorzugsweise ist dieser Block etwa 3 mm dick, mit einer Seitenlänge von einigen cm. Er wird von dem Unterbau 140 der Wanne, der auch aus einem konventionellen Material gefertigt sein kann, gehalten. Der Unterbau ist mit dem oberen Teil 110 der Wanne verschraubt, wodurch der Aerogel-Block 130 unterhalb der Referenzschicht fixiert ist. Um die Zufuhr des Inhibitors, typischerweise Sauerstoff, ggf. in Form von Luft, durch den Aerogel-Block hindurch zu erleichtern bzw. zu ermöglichen, sind Versorgungskanäle 150 vorhanden. Zu Stabilisierungszwecken sowie zum Schutz des Aerogel-Blocks vor mechanischen Beschädigungen ist es somit möglich, den Aufbau nach unten mit z.B. einer Glasplatte abzuschließen (nicht dargestellt). Alternativ kann der Unterbau 140 der Wanne 100 auch nach unten offen sein.

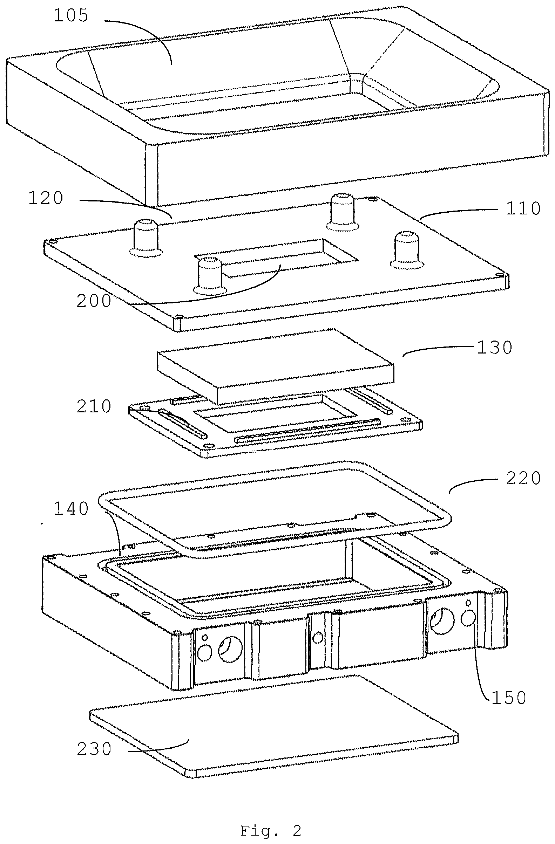

Die einzelnen Komponenten der erfindungsgemäßen Wanne sind in der Explosionsdarstellung in Fig. 2 zu sehen. Die Wand 105 und der äußere Bereich 110 des Wannenbodens können aus einem konventionellen Material gefertigt sein. Der äußere Bereich 110 des Wannenbodens weist auch die Abdeckungen 120 für die Montageschrauben auf. Dort, wo sich im Betrieb die Referenzschicht befindet, hat diese Komponente eine Aussparung 200, unterhalb welcher der Aerogel-Block 130 angebracht wird. Der Halter 210 dient zur Fixierung dieses Blocks 130 und wird mittels der (nicht dargestellten) Montageschrauben an den äußeren Bereich 110 des Wannenbodens geschraubt. Zu Dichtungszwecken ist noch ein O-Ring 220 vorhanden, der trotz des mehrteiligen Aufbaus ein Auslaufen der Stereolithographie-Flüssigkeit aus der Wanne 100 und das Ausdringen des gasförmigen Inhibitors verhindert, und somit eine dichte Kammer schafft. Umgeben werden diese Teile von dem Wannenunterbau 140, der Versorgungskanäle 150 für beispielsweise Luft oder Sauerstoff aufweisen kann. Diese sind notwendig, wenn der Aufbau nach unten durch eine Glasplatte 230 o.ä. abgeschlossen wird. Hierbei wird ein geeignetes Material (z.B. Spezialglas, geeigneter durchsichtiger Kunststoff, Floatglas, Saphierglas, PMMA bzw. Plexiglas o.ä.) ausgewählt, welches für die bei der Stereolithographie verwendete Strahlung, z.B. UV-Strahlung, durchlässig ist.

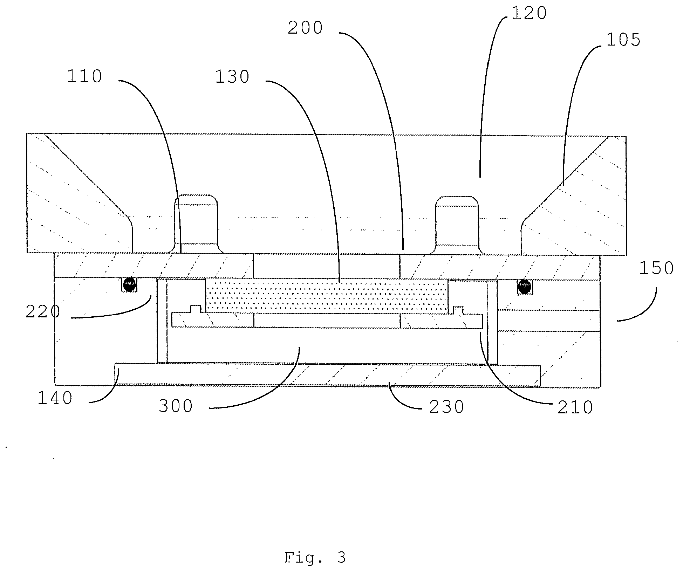

Fig. 3 zeigt dieselbe Wanne in einem schematischen Querschnitt. Hier ist zusätzlich zu erkennen, dass sich bei der dargestellten Ausführungsform zwischen dem mit dem Halter 210 fixierten Aerogel-Block 130 und der Glasplatte 230 ein Hohlraum 300 befindet, der über die Versorgungskanäle 150 mit Inhibitor-Gas versorgt werden kann. Diese Anordnung mit dem Hohlraum 300 ist vorteilhaft, weil so eine größere Außenfläche des Aerogel-Blocks 130 den Inhibitor aufnehmen kann, als bei einer vollständigeren Umschließung des Blocks - in dem Fall stünde lediglich die Querschnittsfläche der Versorgungskanäle 150 zur Verfügung.

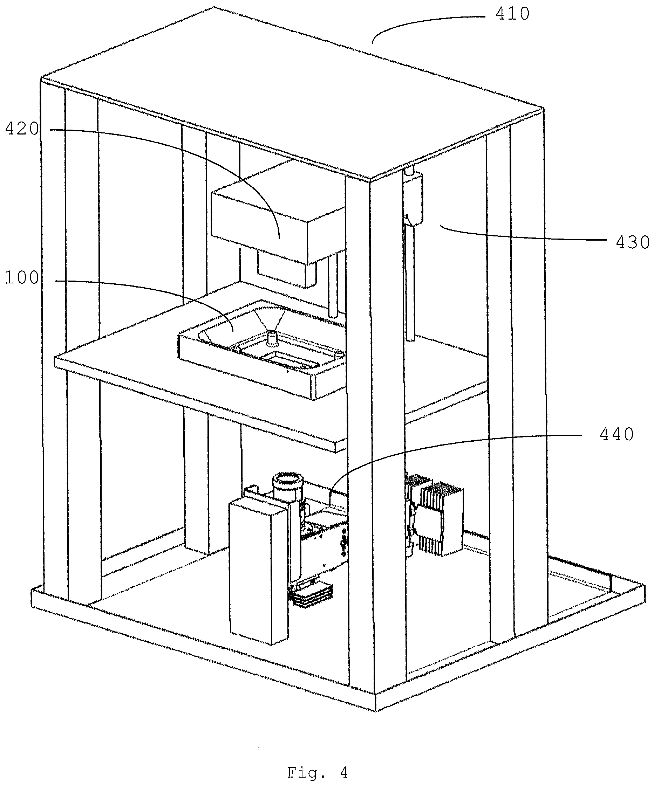

Der Einsatz einer erfindungsgemäßen Wanne 100 in einer Stereolithographie-Anlage 410, das nach dem Überkopf-Verfahren arbeitet, ist in Fig. 4 zu sehen. Oberhalb der Wanne befindet sich die Aufhängevorrichtung 420, an der das zu erzeugende Werkstück (nicht dargestellt) befestigt wird. Die Höhenverstellung 430 bewirkt, dass die Aufhängevorrichtung sich im Betrieb schichtweise oder kontinuierlich nach oben bewegt, wodurch das Werkstück z.B. Schicht für Schicht angehoben wird, so dass in der Referenzschicht zwischen Werkstück und Wannenboden jeweils eine neue Schicht verfestigt werden kann. Die Beleuchtungseinheit 440 sorgt dafür, dass die zur Verfestigung der verwendeten Flüssigkeit notwendige Strahlung an den entsprechenden Stellen (durch den Wannenboden hindurch) fokussiert wird. Sofern die Apparatur nicht zu groß wird, können aufwändige mechanische Rüttel- oder Abschervorrichtungen zwecks Abtrennens des verfestigten Materials vom Wannenboden entfallen.

Es sind zahlreiche Abwandlungen und Weiterbildungen der beschriebenen Ausführungsbeispiele verwirklichbar.

So wird die Aufgabe von einer Stereolithographie-Anlage der eingangs beschriebenen Art gelöst, in dem ein mehrteiliger Aufbau der Referenzfläche (Basis) geschaffen wird, die für die Aushärtung auslösende Strahlung zumindest teilweise durchlässig ist und zumindest ein Teil oder eine Schicht aus einem Material besteht, das maßgeblich, also beispielsweise zumindest zu 30%, 40%, 50% bevorzugt zu 80%, 90% oder mehr, aus einem Gas oder Gasgemisch (z.B. Luft) besteht, in dem zumindest ein Inhibitor zu einem gewissen Prozentsatz gelöst ist, oder gänzlich aus einem Inhibitor (zum Beispiel Sauerstoff) besteht, trotzdem jedoch in der Lage ist, gemeinsam mit einer Matrix eine räumliche Struktur bzw. einen Körper zu bilden. Hierbei wird unter Körper jegliche geometrische Ausbildung verstanden, beispielsweise kann ein möglicher Körper ein Quader mit einer Dicke von 10 mm und Kantenlängen von 100 mm sein.

Die erfindungsgemäße Lösung sieht anstatt eines Werkstoffes, der im Wesentlichen nicht aus gasförmigen Bestandteilen besteht (wie zum Beispiel Glas, Fluoro-Polymer, Silikon), einen Basiskörper vor, auf dem eine Schutzmembran aufgebracht werden kann, der zum überwiegenden Teil seines Volumens aus einem Gas oder Gasgemisch besteht bzw. zum überwiegenden Teil von diesem gefüllt oder gesättigt ist und für die eingesetzte elektromagnetische Strahlung zumindest teilweise durchlässig ist.

Durch diese Ausführung kann sichergestellt werden, dass nicht nur durch die Basis Inhibitor gefördert werden kann und ggf. gespeichert werden kann, vielmehr kann diese Basis selbst zu einem Großteil aus dem Inhibitor bestehen. Diese Basis kann mit verschiedenen Materialen angereichert werden wie beispielsweise PDMS (Silikon), um Einfluss auf die Transparenz sowie die mechanische und chemische Stabilität zu nehmen. Auch kann die Basis mit einer Membran, die eine gewisse Selektivität aufweist, verbunden werden, beispielwiese durch den Einsatz eines Adhäsives wie Silikon, um die chemische Stabilität zu verbessern. Da die Basis selbst eine hohe Permeabilität für mögliche Inhibitoren besitzt bzw. sogar nahezu vollständig aus diesem bestehen kann (zum Beispiel zu mehr als 40%), wie zum Beispiel Sauerstoff, können mögliche und normalerweise notwendige Inhibitor-Zuführungen, wie Flächen oder Kanäle, auf ein Minimum reduziert werden. Dadurch kann ein Aufbau realisiert werden, in dem die Basis von herkömmlichen Konstruktionsmaterialen, die über eine geringe Inhibitor-Durchlässigkeit verfügen, zusätzlich gestützt oder umgeben werden kann. Weiterhin kann nur über einem kleinen Bereich der Mantelfläche, wenn überhaupt, Inhibitor zugeführt werden. Dies ermöglicht eine einfache konstruktive Lösung und Integration in ein technisches Bauteil wie beispielsweise eine Wanne, eine Kartusche oder sonstigen Ausführungsformen, die geeignet sind, ein fotoreaktives Material aufzunehmen und in einer Stereolithographie-Anlage zu prozessieren.

Die Erfindung gestattet auch eine nahezu geometrisch beliebig skalierbare Ausführung der Basis, da im Gegensatz zu anderen Materialen die Basis bereits selbst zu einem Großteil aus Inhibitor besteht oder diesen aufnehmen kann, können geometrische Restriktionen aufgrund einer minimal notwendigen Permeabilität herkömmlicher Materialien überwunden werden. Somit können Basisdicken im Millimeter- bzw. Zentimeter-Bereich problemlos verwirklicht werden, um so selbst bei großen Ausdehnungen eine ausreichende Steifigkeit zu garantieren. Die Basis kann vorteilhafterweise so geformt sein, dass die Zuführung des Inhibitors aus sich selbst wie auch aus der Umwelt oder einer speziellen Prozesskammer von allen Seiten und Richtungen ermöglicht. Dabei kann der Inhibitor durch Änderung des Umgebungsdruckes zugeführt und/oder abgeführt werden. Gemäß einem Weiterbildungsaspekt der Erfindung kann die Basis Kanalstrukturen aufweisen, die einen Inhibitorfluss ermöglichen, wobei diese in einem Herstellungsprozess mit der Basis selbst erzeugt werden können (zum Beispiel durch Gießen).

Erfindungsgemäß erfolgt der Inhibitorfluss durch/über die gesamte Oberfläche der Basis durch die Schutzmembrane in das fotoreaktive Material, wobei die Zufuhr des Inhibitors nicht gleichmäßig über die gesamte oder einen Teil der Oberfläche erfolgen muss.

Bevorzugt besteht die Basis aus einem sogenannten Aerogel, Nanofoam oder einem X-Aerogel oder aus artverwandten Materialien, die zumindest teilweise für die eingesetzte Strahlung transparente, nano-, mikro- sowie mesoporösen Struktur oder eine Kombination daraus (zum Beispiel mit einem Porendurchmesser von 2 bis 200 nm) aufweisen können. Besonders bevorzugt besteht die Basis aus einem Verbund aus einem Aerogel, X-Aerogel oder aus Hybridformen eines Aerogels und einer Fluoropolymer-Schutzschicht (Teflon AF) oder einer anderen permeablen Membran, die mit der Basis gekoppelt ist.

Erfindungsgemäß kann die Aerogel-Basis durch superkritisches Trocknen erzeugt werden.

Erfindungsgemäß kann die Basis aus zumindest einem Material, bevorzugt aus einer Kombination von Materialien, bevorzugt aus einer Kombination aus verschiedenen Aerogel-Materialien bestehen.

Erfindungsgemäß kann die Dichte der Basis entsprechende der Kombination der Materialien innerhalb der Basis, sowie über den gesamten Verbundkörper über Dichtegradienten sowie Sprünge verfügen.

Zur Unterstützung des Ablöseprozesses kann die Basis gegenüber dem Bauteilträger (Bauteilplattform) räumlich bewegt werden. Dabei können ein Kippen der Basis gegenüber dem Bauteilträger erfolgen sowie auch eine Translation.

Erfindungsgemäß besitzt die Basis Kanäle, die zur Temperierung ihrer Oberfläche dienen. Dies ist aufgrund der sehr guten Isolierung der eingesetzten Werkstofftypen sinnvoll.

Glossar

3D-Druck, Stereolithographie

Der 3D-Druck ist ein generatives Fertigungsverfahren, nach dem Aufbauprinzip als additive Fertigung bezeichnet. Beim 3D-Druck werden dreidimensionale Werkstücke schichtweise aufgebaut. Der Aufbau erfolgt computergesteuert aus einem oder mehreren flüssigen oder festen Werkstoffen nach vorgegebenen Maßen und Formen (CAD). Beim Aufbau finden Härtungs- oder Schmelzprozesse statt. Typische Werkstoffe für das 3D-Drucken sind Kunststoffe, Kunstharze, Keramiken oder Metalle. Stereolithographie ist die Variante davon, bei der ein Werkstück durch materialisierende (Raster-)Punkte schichtenweise aufgebaut wird. Die Fertigung eines Teils oder mehrerer Teile gleichzeitig erfolgt üblicherweise vollautomatisch aus am Computer erstellten CAD-Daten.

Beispielsweise wird ein lichtaushärtender Kunststoff (Photopolymer), zum Beispiel Acryl-, Epoxid- oder Vinylesterharz, von einer geeigneten, von oben scheinenden Lichtquelle, z.B. einem Laser (oder auch einer pixelbasierten, evtl. inkohärenten Lichtquelle, z.B. einem MEMS- oder DLP-Chip), in dünnen Schichten ausgehärtet. Die Prozedur geschieht in einem Bad, das mit den Basismonomeren des lichtempfindlichen (photosensitiven) Kunststoffes gefüllt ist. Nach jedem Schritt wird das Werkstück einige Millimeter in die Flüssigkeit abgesenkt und auf eine Position zurückgefahren, die um den Betrag einer Schichtstärke unter der vorherigen liegt. Der flüssige Kunststoff über dem Teil wird (durch einen Wischer) gleichmäßig verteilt oder aufgrund der Anwesenheit eines Deckels automatisch angesogen. Dann fährt die Lichtquelle, die von einem Computer über bewegliche Spiegel gesteuert wird, auf der neuen Schicht pixelweise über die Flächen, die ausgehärtet werden sollen. Alternativ kann die Schicht- bzw. Bildinformation auch z.B. durch eine Maske oder die Projektion eines Bildes innerhalb der Projektionsfläche in allen Bereichen simultan erzeugt werden. Nach dem Aushärten erfolgt der nächste Schritt, sodass nach und nach ein dreidimensionales Modell entsteht.

Für größere Werkstücke hat diese Vorgehensweise den Nachteil, dass das Bad entsprechend tief und mit einer unnötig großen Menge des flüssigen Kunststoffmaterials gefüllt sein muss. Das Überkopf-Verfahren (siehe dort) kann hier Abhilfe schaffen. (Nach https://de.wikipedia.org/wiki/3D-Druck und https://de.wikipedia.org/wiki/Stereolithografie.)

Aerogel

Aerogele sind hochporöse Festkörper, bei denen bis zu 99,98% des Volumens aus Poren bestehen. Es gibt verschiedene Arten von Aerogelen, wobei solche auf Silicatbasis am verbreitetsten sind. Andere Materialien, beispielsweise auf Kunststoff- oder Kohlenstoffbasis, kommen in Spezialfällen zur Anwendung. Grundsätzlich können alle Metalloxide, Polymere und einige andere Stoffe als Ausgangsbasis für die Aerogelsynthese mittels eines Sol-Gel-Prozesses verwendet werden.

Aerogele weisen eine stark dendritische Struktur auf, also eine Verästelung von Partikelketten mit sehr vielen Zwischenräumen in Form von offenen Poren. Diese Ketten besitzen Kontaktstellen, so dass sich das Bild eines stabilen dreidimensionalen Netzes ergibt. Dessen Aggregate verfügen über eine fraktale Dimension, sind also in einem gewissen Ausmaß selbstähnlich.

Die Porengröße liegt im Nanometer-Bereich, und die inneren Oberflächen können mit bis zu 1000 $m^2/g$ außergewöhnlich groß werden. Dadurch können Aerogele u.a. als Isolier- oder Filtermaterial eingesetzt werden. Darüber hinaus besteht die Möglichkeit, biologisch aktive Moleküle, Proteine oder gar ganze Zellen einzulagern. Aerogele halten 14 Einträge im Guinness-Buch der Rekorde für Materialeigenschaften, inklusive "bester Isolator" und "leichtester Feststoff". Als Rekordhalter in der Kategorie "Feststoff mit der geringsten Dichte" wurde 2012 Aerographit mit 99,99% Luft und 0,01% graphitischem Kohlenstoff entwickelt.

Die hohe optische Transparenz, zusammen mit einem Brechungsindex von etwa 1,007 bis 1,24 und einem typischen Wert von 1,02, macht Aerogele auch in optischer Hinsicht interessant. Ein Silicat-Aerogel erscheint vor dunklem Hintergrund milchig-blau, weil das Siliciumdioxid die kürzeren Wellenlängen (das heißt, die blauen Anteile des weißen Lichts) mehr streut als die längerwellige Strahlung. Trotz seiner durchsichtigen Erscheinung fühlt sich das Aerogel wie harter Kunststoff-Schaum an.

Die einzelnen Partikel der Silicat-Aerogele sind rund 1 - 10 nm groß, der Abstand zwischen den Ketten beträgt etwa 10 - 100 nm. Silicat-Aerogele weisen zylinderförmige sog. Mesoporen auf. Diese sind recht gut zugänglich und besitzen definitionsgemäß einen Durchmesser von 2 - 50 nm, wobei die Porosität im Bereich von 80 - 99,8% liegt. Die Rohdichte bewegt sich folglich im Bereich von 0,16 - 500 $mg/cm^3$ mit einem typischen Wert von 100 $mg/cm^3$, wohingegen die Reindichte bei 1700 - 2100 $mg/cm^3$ liegt. Dementsprechend weisen Silicat-Aerogele eine mit 100 - 1.600 $m^2/g$ und einem typischen Wert von 600 $m^2/g$ sehr hohe spezifische Oberfläche auf.

Die Wärmeleitfähigkeit in Luft (bei 300 K) ist mit 0,017 - 0,021 W/(mK) und einem typischen Wert von 0,02 W/(mK) außerordentlich gering, was den Aerogelen eine hohe Temperaturstabilität auch unter extremen Bedingungen verleiht und sie zu den bisher besten Wärmeisolatoren macht.

Silicat-Aerogele können nicht von flüssigen Metallen benetzt oder chemisch angegriffen werden, sie sind also ihnen gegenüber chemisch inert. Ihr Schmelzpunkt liegt bei etwa 1.200 °C. Zudem sind sie unbrennbar und ungiftig. Allerdings nehmen sie Luftfeuchtigkeit auf und neigen beim Trocknen zur Rissbildung.

Das Elastizitätsmodul bewegt sich in einem Bereich von 0,002 - 100 MPa, mit einem typischen Wert von 1 MPa. (Nach https://de.wikipedia.org/wiki/Aerogel.)

Basis

Bei dieser Erfindung ist unter Basis der Bereich des Bodens der Wanne zu verstehen, oberhalb dessen sich bei der Überkopf-Stereolithographie die Referenzschicht befindet.

dotiertes Aerogel

Unter einem dotierten Aerogel, auch X-Aerogel oder Hybrid-Aerogel genannt, ist ein Aerogel zu verstehen, dessen Matrix gezielt mit anderen Molekülen "verunreinigt" ist, ähnlich wie die Dotierung bei einem Halbleiter (bei dem allerdings einzelne Atome in die Kristallstruktur eingebaut werden). Von Interesse sind vor allem Dotierungen mit Nanozellulose oder einem Silikon, z.B. PDMS. Durch solche Dotierungen können die mechanischen (z.B. Festigkeit, Zähigkeit), chemischen oder optischen Eigenschaften eines Aerogels verändert werden.

Dazu wird das dotierte Aerogel typischerweise aus einer flüssigen Mixtur aus einzelnen Komponenten in einem Sol-Gel Prozess gebildet, wobei die Zusätze Teil der Mixtur sind. In dem Sol-Gel-Prozess wird die Matrix des Aerogels gemeinsam und gleichzeitig mit der Anlagerung des Additivs gebildet.

Fluorpolymer, auch Fluoropolymer

Fluorpolymere oder auch Fluorkunststoffe sind Polymere, bei denen meist ein großer Teil oder sogar alle sonst enthaltenen Wasserstoffatome durch Fluor ersetzt sind. Die größte wirtschaftliche Bedeutung besitzt Polytetrafluorethen (PTFE), das unter den Handelsnamen Teflon vertrieben wird.

Fluorpolymere besitzen eine hohe chemische und thermische Stabilität, gute elektrische Isoliereigenschaften, hervorragende Witterungsbeständigkeit, antiadhäsives Verhalten und sind unbrennbar. Des Weiteren zeichnen sie sich durch eine gute Kerbschlagzähigkeit sowie Beständigkeit bei hohen Temperaturen aus. Aus dem antiadhäsiven Verhalten folgen eine geringe Benetzbarkeit sowie gute Gleiteigenschaften. Schließlich sind Fluorpolymere physiologisch unbedenklich. Nachteilig sind die hohen Kosten sowie die schwierige Verarbeitung. (Nach https://de.wikipedia.org/wiki/Fluorpolymere.)

Inhibitor

Ein Inhibitor ist ein Hemmstoff, der eine oder mehrere Reaktionen verlangsamt oder verhindert. Im Zusammenhang mit der vorliegenden Erfindung ist unter Inhibitor stets ein Stoff zu verstehen, der die Verfestigung der Substanz, aus der mittels Stereolithographie ein Gegenstand erzeugt werden soll, hemmt. Im Falle von Stereolithographie aus Kunstharzen dient z.B. häufig Sauerstoff als Inhibitor, der die Photopolymerisation unterdrückt.

Porengröße

Zur Bestimmung des Porendurchmessers gibt es physikalische Methoden wie die Quecksilberporosimetrie, die jedoch eine bestimmte Form der Poren (wie zylinderförmig oder aneinandergereihte sphärische Löcher) voraussetzen. Für Silicat-Aerogele ist die Quecksilberporosimetrie geeignet. Diese Technik umfasst das Eindringen einer nichtbenetzenden Flüssigkeit, wie Quecksilber, bei hohem Druck in ein Material unter Verwendung eines Porosimeters. Die Porengröße wird als Funktion des äußeren Drucks bestimmt, der notwendig ist, um die Flüssigkeit in eine Pore gegen die Oberflächenspannung der Flüssigkeit zu drücken.

Für zylindrische Poren gilt die sogenannte Washburn-Gleichung:

$$P_L - P_G = 4\ \sigma\ cos\ \theta\ /\ D_P,$$

wobei

$P_L$ = Druck der Flüssigkeit,

$P_G$ = Druck des zu verdrängenden Gases,

$\sigma$ = Oberflächenspannung der Flüssigkeit,

$\theta$ = Kontaktwinkel der Flüssigkeit auf dem Wandmaterial der Poren, und

$D_P$ = Porendurchmesser.

Die Technik wird in der Regel unter Vakuum durchgeführt. Der Kontaktwinkel von Quecksilber mit den meisten Feststoffen liegt zwischen 135° und 142°. Die Oberflächenspannung von Quecksilber bei 20 °C unter Vakuum beträgt 480 mN/m. Durch Einsetzen erhält man:

$$D_P\ =\ 1470\ kPa\ \mu m\ /\ P_L.$$

Mit zunehmendem Druck nimmt auch das kumulative Porenvolumen zu. Aus dem kumulativen Porenvolumen kann die mittlere Porengröße bestimmt werden. Eine Ableitung der kumulativen Porenvolumenverteilung ergibt eine differentielle Porenradienverteilung. (Nach https://de.wikipedia.org/wiki/Quecksilberporosimetrie.) Die Porengröße kann z.B. gemäß der Norm ISO 15901-1:2016-04 gemessen werden.

Referenzebene, Referenzschicht

Die Referenzebene oder genauer Referenzschicht bezeichnet bei der Stereolithographie diejenige Schicht, in der gerade am herzustellenden Gegenstand ein Schichtaufbau stattfindet, also das flüssige Material (z.B. Kunstharz) durch z.B. Beleuchtung mit einer geeigneten Lichtquelle photopolymerisiert bzw. verfestigt wird. Beim klassischen Verfahren (siehe oben) befindet sich diese Schicht an der Oberseite des Werkstücks unmittelbar unter der Flüssigkeitsoberfläche. Beim Überkopf-Verfahren befindet sich diese Schicht an der Unterseite des Werkstücks.

Silikon

Silikone, chemisch genauer Poly(organo)siloxane, ist eine Bezeichnung für eine Gruppe synthetischer Polymere, bei denen Siliciumatome über Sauerstoffatome verknüpft sind.

Dabei können Molekülketten und/oder -netze auftreten. Die restlichen freien Valenzelektronen des Siliciums sind durch Kohlenwasserstoffreste (meist Methylgruppen) abgesättigt. Silikone gehören damit zur Gruppe der Siliciumorganischen Verbindungen. Aufgrund ihres typisch anorganischen Gerüsts einerseits und der organischen Reste andererseits nehmen Silikone eine Zwischenstellung zwischen anorganischen und organischen Verbindungen ein, insbesondere zwischen anorganischen Silikaten und organischen Polymeren. Sie sind in gewisser Weise Hybride und weisen ein einzigartiges Eigenschaftsspektrum auf, das von keinem anderen Kunststoff erreicht wird.

In der Natur kommen ausschließlich anorganische Siliciumverbindungen vor, nämlich Siliciumdioxid, Silicate und Kieselsäure. Alle anderen Siliciumverbindungen einschließlich der Silikone sind synthetischen Ursprungs. (Nach https://de.wikipedia.org/wiki/Silikone.)

Im Rahmen dieser Erfindung ist aus dieser Stoffklasse vor allem Polydimethylsiloxan (PDMS) von Bedeutung, welches über eine gewisse Sauerstoff-Durchlässigkeit verfügt.

Teflon AF

Handhabbare Bezeichnung für Tetrafluorethylen/Bistrifluormethyl-Difluor-Dioxalan bzw. Polytetrafluorethylen-4,5-Difluor-2,2-bis(trifluormethyl)-1,3-dioxol. Teflon ist dabei Polytetrafluorethen (PTFE), AF steht für "Amorph Fluor". (Vgl. https://de.wikipedia.org/wiki/Kurzzeichen_%28Kunststoff%29. ) Überkopf-Stereolithographie

Beim Überkopf-Verfahren wird die typische Stereolithographie-Anordnung (siehe oben) umgekehrt. Das Werkstück hängt an einer Aufhängevorrichtung und taucht in eine Wanne mit der Flüssigkeit ein. Die Referenzschicht befindet sich an der Unterseite des Werkstücks zwischen Werkstück und Wannenboden. Die Beleuchtung erfolgt durch den Wannenboden, der für das verwendete Licht durchlässig ausgebildet ist. Mittels der Aufhängevorrichtung wird das Werkstück schichtweise angehoben, während schichtweise auf der Unterseite neues Material aufgebaut wird. Dabei muss das Anheben in einer Weise geschehen, die sicherstellt, dass genügend Flüssigkeit in die Referenzschicht nachfließt, bevor dort wieder Material verfestigt wird. Bei besonderen Ausführungsformen dieses Verfahrens kann der Aufbau auch kontinuierlich ablaufen.

**Patentansprüche**

1. Behälter (100) zur Aufnahme einer fotosensitiven Flüssigkeit zur Verwendung in einer Stereolithographie-Anlage (410), in der eine Referenzschicht zum schichtweisen oder kontinuierlichen Aufbauen von Werkstücken mit Strahlung belichtet wird, wobei mindestens ein Element (130) des Behälters, das unmittelbar an die Referenzschicht grenzt, aus zumindest einem Material besteht, welches für die Strahlung durchlässig ist und Strukturen und/oder Poren aufweist, die in der Lage sind, einen Inhibitor und/oder ein Inhibitor-Gemisch zu speichern oder aufzunehmen und abzugeben, **dadurch gekennzeichnet,** **dass** das zumindest eine Material des mindestens einen Elements (130) des Behälters ein Festkörper ist, der zu mindestens 70 Vol-%, vorzugsweise zu mindestens 80 Vol-%, vorzugsweise zu mindestens 90 Vol-%, vorzugsweise zu mindestens 95 Vol-%, vorzugsweise zu mindestens 98 Vol-%, vorzugsweise zu mindestens 99 Vol-%, aus offenzelligen Poren besteht.

2. Behälter (100) nach dem vorhergehenden Anspruch, **dadurch gekennzeichnet,** **dass** der Behälter zur Aufnahme der fotosensitiven Flüssigkeit eine Wanne zur Verwendung in einer Stereolithographie-Anlage (410), welche nach dem Überkopf-Verfahren arbeitet, ist; und dass das Element (130) der Wanne, das unmittelbar an die Referenzschicht grenzt, zumindest ein Teil des Bodens der Wanne ist.

3. Behälter (100) nach Anspruch 1, **dadurch gekennzeichnet,** **dass** der Behälter zur Aufnahme der fotosensitiven Flüssigkeit zur Verwendung in einer Auflicht-Stereolithographie-Anlage (410) dient; und **dass** das Element (130) des Behälters, das unmittelbar an die Referenzschicht grenzt, zumindest ein Teil des Deckels des Behälters ist.

4. Behälter (100) nach einem der vorhergehenden Ansprüche, **dadurch gekennzeichnet,** **dass** die Poren eine Porengröße zwischen 2 und 200 nm, vorzugsweise zwischen 2 und 50 nm, vorzugsweise zwischen 30 und 50 nm aufweisen.

5. Behälter (100) nach dem vorhergehenden Anspruch, **dadurch gekennzeichnet,** **dass** das Material ein nanoporöses Komposit oder ein nanoporöses Glas ist.

6. Behälter (100) nach Anspruch 4, **dadurch gekennzeichnet,** **dass** das Material ein Aerogel ist.

7. Behälter (100) nach dem vorhergehenden Anspruch, **dadurch gekennzeichnet,** **dass** das Aerogel dotiert ist.

8. Behälter (100) nach dem vorhergehenden Anspruch, **dadurch gekennzeichnet,**

**dass** das Aerogel mit Nanozellulose und/oder Polydimethylsiloxan dotiert ist.

9. Behälter (100) nach einem der vorhergehenden Ansprüche,
**dadurch gekennzeichnet,**
**dass** das Element (130) des Bodens der Wanne einschichtig ausgeführt ist.

10. Behälter (100) nach einem der Ansprüche 1 bis 8,
**dadurch gekennzeichnet,**
**dass** das Element (130) mindestens zwei Schichten aus unterschiedlichen Materialien aufweist.

11. Behälter (100) nach einem der vorhergehenden Ansprüche,
**dadurch gekennzeichnet,**
**dass** das Element (130) auf derjenigen Seite, die mit der fotosensitiven Flüssigkeit in Kontakt kommt, mit einer semipermeablen Beschichtung beschichtet ist.

12. Behälter (100) nach dem vorhergehenden Anspruch,
**dadurch gekennzeichnet,**
**dass** die Beschichtung zumindest teilweise aus einem Fluoropolymer, bevorzugt Teflon AF, aus Silikon oder aus einem porösen Glas besteht.

13. Behälter (100) nach dem vorhergehenden Anspruch,
**dadurch gekennzeichnet,**
**dass** das Element (130) mit einem Haftvermittler, vorzugsweise einem Silikon, und einer semi-permeablen Membran, vorzugsweise Teflon AF, beschichtet ist.

14. Behälter (100) nach einem der vorhergehenden Ansprüche,
**dadurch gekennzeichnet,**
**dass** das Element (130) so konfiguriert ist, dass die Porengröße des Elements sich über seine räumliche Ausdehnung in mindestens einer Richtung ändert, bevorzugt in Richtung der fotosensitiven Flüssigkeit.

15. Behälter (100) nach einem der vorhergehenden Ansprüche,
**dadurch gekennzeichnet,**
**dass** ein zumindest teilweise geschlossenes Volumen auf der von der fotosensitiven Flüssigkeit abgewandten Seite des Elements (130) ausgebildet ist, das es ermöglicht, Zustandsgrößen sowie die Zusammensetzung der Atmosphäre in dem Volumen zumindest teilweise zu kontrollieren.

16. Behälter (100) nach einem der Ansprüche 2 bis 15, mit einer Verpackung, wobei die Wanne mit einer fotosensitiven Flüssigkeit zur Verwendung in einer Stereolithographie-Anlage (410) gefüllt ist;
wobei die Wanne sich in der Verpackung befindet, welche derart beschaffen ist,
dass die fotosensitive Flüssigkeit in der Wanne gehalten wird; und
dass die fotosensitive Flüssigkeit gegen die zur Stereolithographie verwendete Strahlung abgeschirmt ist.

17. Behälter (100) nach einem der vorhergehenden Ansprüche,
**dadurch gekennzeichnet,**
**dass** das Element (130) von einem Trägermaterial, das für die eingesetzte Strahlung transparent ist, zumindest bereichsweise mechanisch unterstützt wird.

18. Stereolithographie-Anlage, (410), welche nach dem Überkopf-Verfahren arbeitet, mit mindestens einer Wanne (100) zur Aufnahme einer fotosensitiven Flüssigkeit nach einem der Ansprüche 2 oder 4 bis 17.

**Claims**

1. A container (100) for holding a photosensitive liquid for use in a stereolithographic system (410) in which a reference layer is exposed to radiation for the layer-by-layer or continuous construction of workpieces, wherein at least one element (130) of the container, which is directly adjacent to the reference layer, consists of at least one material that is permeable to the radiation and has structures and/or pores that can store or hold and discharge an inhibitor and/or an inhibitor mixture,
**characterised in that**
the at least one material of the at least one element (130) of the container is a solid which consists of open-cell pores to an extent of at least 70 vol.%, preferably at least 80 vol.%, preferably at least 90 vol.%, preferably at least 95 vol.%, preferably at least 98 vol.%, preferably at least 99 vol.%.

2. The container (100) according to the preceding claim,
**characterised in that**
the container for holding the photosensitive liquid is a vat for use in a stereolithographic system (410) which works according to the overhead method; and
**in that** the element (130) of the vat directly adjacent to the reference layer is at least part of the bottom of the vat.

3. The container (100) according to claim 1,

    **characterised in that**

the container is used to hold the photosensitive liquid for use in a reflected light stereolithographic system (410); and

the element (130) of the container directly adjacent to the reference layer is at least part of the lid of the container.

4. The container (100) according to one of the preceding claims,
**characterised in that**
the pores have a pore size between 2 and 200 nm, preferably between 2 and 50 nm, preferably between 30 and 50 nm.

5. The container (100) according to the preceding claim,
**characterised in that**
the material is a nanoporous composite or a nanoporous glass.

6. The container (100) according to claim 4,
**characterised in that**
the material is an aerogel.

7. The container (100) according to the preceding claim,
**characterised in that**
the aerogel is doped.

8. The container (100) according to the preceding claim,
**characterised in that**
the aerogel is doped with nanocellulose and/or polydimethylsiloxane.

9. The container (100) according to one of the preceding claims,
**characterised in that**
the element (130) of the bottom of the vat is made in one layer.

10. The container (100) according to one of claims 1 to 8,
**characterised in that**
the element (130) has at least two layers made of different materials.

11. The container (100) according to one of the preceding claims,
**characterised in that**
the element (130) is coated with a semi-permeable coating on the side that comes into contact with the photosensitive liquid.

12. The container (100) according to the preceding claim,
**characterised in that**
the coating consists at least partially of a fluoropolymer, preferably Teflon AF, of silicone or of a porous glass.

13. The container (100) according to the preceding claim,
**characterised in that**
the element (130) is coated with an adhesion promoter, preferably a silicone, and a semi-permeable membrane, preferably Teflon AF.

14. The container (100) according to one of the preceding claims,
**characterised in that**
the element (130) is configured such that the pore size of the element changes over its spatial extent in at least one direction, preferably in the direction of the photosensitive liquid.

15. The container (100) according to one of the preceding claims,
**characterised in that**
an at least partially closed volume is formed on the side of the element (130) facing away from the photosensitive liquid, which makes it possible to at least partially control state variables and the composition of the atmosphere in the volume.

16. The container (100) according to one of claims 2 to 15, having a packaging, wherein

the vat is filled with a photosensitive liquid for use in a stereolithographic system (410);
wherein the vat is in the packaging, which is provided such that
the photosensitive liquid is held in the vat; and
the photosensitive liquid is shielded from the radiation used for stereolithography.

17. The container (100) according to one of the preceding claims,
**characterised in that**
the element (130) is at least partially mechanically supported by a carrier material that is transparent to the radiation used.

18. A stereolithographic system (410), which works according to the overhead method, having at least one vat (100) for holding a photosensitive liquid according to one of claims 2 or 4 to 17.

**Revendications**

1. Récipient (100) destiné à la réception d'un liquide photosensible destiné à être utilisé dans une installation de stéréolithographie (410) dans laquelle une couche de référence, pour la construction en couches ou continue de pièces, est exposée à un rayonnement, dans lequel au moins un élément (130) du récipient, lequel est directement adjacent à la couche de référence, est constitué d'au moins un matériau, lequel est transparent au rayonnement et lequel comporte des structures et/ou des pores, lesquels sont capables de stocker ou d'absorber et d'émettre un inhibiteur et/ou un mélange d'inhibiteurs,

**caractérisé en ce que**

l'au moins un matériau de l'au moins un élément (130) du récipient est un solide, lequel est constitué d'au moins 70 % en volume, de préférence d'au moins 80 % en volume, de préférence d'au moins 90 % en volume, de préférence d'au moins 95 % en volume, de préférence d'au moins 98 % en volume, de préférence d'au moins 99 % en volume, de pores à cellules ouvertes.

2. Récipient (100) selon la revendication précédente, **caractérisé en ce que**

le récipient destiné à la réception du liquide photosensible est une cuve destinée à être utilisée dans une installation de stéréolithographie (410), laquelle fonctionne selon le procédé par le haut; et que l'élément (130) de la cuve, lequel est directement adjacent à la couche de référence, fait au moins partie du fond de la cuve.

3. Récipient (100) selon la revendication 1,

**caractérisé en ce que**

le récipient destiné à la réception du liquide photosensible est destiné à être utilisé dans une installation de stéréolithographie (410) à lumière réfléchie ; et

que l'élément (130) du récipient, lequel est directement adjacent à la couche de référence, fait au moins une partie du couvercle du récipient.

4. Récipient (100) selon l'une quelconque des revendications précédentes, **caractérisé en ce que** les pores présentent une taille de pore comprise entre 2 et 200 nm, de préférence entre 2 et 50 nm, de préférence entre 30 et 50 nm.

5. Récipient (100) selon la revendication précédente, **caractérisé en ce que**

le matériau est un composite nanoporeux ou un verre nanoporeux.

6. Récipient (100) selon la revendication 4, **caractérisé en ce que**

le matériau est un aérogel.

7. Récipient (100) selon la revendication précédente, **caractérisé en ce que**

l'aérogel est dopé.

8. Récipient (100) selon la revendication précédente, **caractérisé en ce que**

l'aérogel est dopé avec de la nanocellulose et/ou du polydiméthylsiloxane.

9. Récipient (100) selon l'une quelconque des revendications précédentes, **caractérisé en ce que** l'élément (130) du fond de la cuve est réalisé en une seule couche.

10. Récipient (100) selon l'une quelconque des revendications 1 à 8, **caractérisé en ce que** l'élément (130) comporte au moins deux couches de matériaux différents.

11. Récipient (100) selon l'une quelconque des revendications précédentes, **caractérisé en ce que** l'élément (130) est recouvert d'un revêtement semi-perméable du côté, lequel entre en contact avec le liquide photosensible.

12. Récipient (100) selon la revendication précédente, **caractérisé en ce que**

le revêtement est au moins partiellement constitué d'un polymère fluoré, de préférence du Téflon AF, de silicone ou d'un verre poreux.

13. Récipient (100) selon la revendication précédente, **caractérisé en ce que**

l'élément (130) est revêtu d'un promoteur d'adhérence, de préférence d'une silicone, et d'une membrane semi-perméable, de préférence de Téflon AF.

14. Récipient (100) selon l'une quelconque des revendications précédentes, **caractérisé en ce que** l'élément (130) est conçu de telle sorte que la taille des pores de l'élément change sur son étendue spatiale dans au moins une direction, de préférence dans la direction du liquide photosensible.

15. Récipient (100) selon l'une quelconque des revendications précédentes,

**caractérisé en ce que**

un volume au moins partiellement fermé est formé du côté de l'élément (130) opposé au liquide photosensible, ce qui permet de contrôler au moins partiellement des grandeurs d'état et la composition de l'atmosphère dans le volume.

16. Récipient (100) selon l'une quelconque des revendications 2 à 15, comportant un emballage, dans lequel

la cuve est remplie d'un liquide photosensible destiné à être utilisé dans une installation de stéréolithographie (410) ;

dans lequel la cuve se trouve dans l'emballage, lequel est conçu de telle sorte que le liquide photosensible est maintenu dans la cuve ; et que le liquide photosensible est protégé du rayonnement utilisé pour la stéréolithographie.

17. Récipient (100) selon l'une quelconque des revendications précédentes, **caractérisé en ce que** l'élément (130) est au moins partiellement supporté mécaniquement par un matériau support transparent au rayonnement utilisé.

18. Installation de stéréolithographie (410), laquelle fonctionne selon le procédé par le haut, comportant au moins une cuve (100) de réception d'un liquide photosensible selon l'une quelconque des revendications 2 ou 4 à 17.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5391072 A
- WO 0172501 A1
- US 20150360419 A1
- DE 202013103446 U1
- US 5545367 A
- US 20130252178 A1
- US 20150309473 A1
- US 20130292862 A1
- EP 1253002 B1
- US 20130295212 A1
- WO 2016149097 A1
- DE 102013215040 A1
- WO 2016149104 A1
- US 20170151718 A1